(19) Europäisches Patentamt
European Patent Office
Office européen des brevets

(11) **EP 2 667 510 A1**

(12) **EUROPEAN PATENT APPLICATION**

(43) Date of publication:
**27.11.2013 Bulletin 2013/48**

(51) Int Cl.:
*H03K 4/00* (2006.01)     *H03K 5/13* (2006.01)

(21) Application number: **12195126.3**

(22) Date of filing: **30.11.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **25.05.2012 CN 201210165540**

(71) Applicants:
- **Hong Fu Jin Precision Industry (ShenZhen) Co., Ltd.**
  **Shenzhen City, Guangdong 518109 (CN)**
- **Hon Hai Precision Industry Co., Ltd.**
  **New Taipei City (TW)**

(72) Inventors:
- **Deng, Xue-Bing**
  **Shenzhen City, Guangdong Province (CN)**
- **WAang, Tao**
  **Shenzhen City, Guangdong Province (CN)**
- **Cheng, Hai-Long**
  **Shenzhen City, Guangdong Province (CN)**

(74) Representative: **Gray, John James**
**Murgitroyd & Company**
**Scotland House**
**165-169 Scotland Street**
**Glasgow G5 8PL (GB)**

(54) **Delay circuit and electronic device having the same**

(57) An electronic device (100) receives a voltage from a power supply (1). The electronic device (100) includes a load (3), a first adjusting module (21), a switching module (23), a delay module (25), and a second adjusting module (27). The first adjusting module (21) produces a working voltage when the electronic device (100) is powered on. The switching module (23) establishes an electrical connection between the first adjusting module (21) and the load (3) when receiving the working voltage, and cuts off the electrical connection when not receiving the working voltage. The delay module (25) delays outputting the working voltage to the load (3) for a first predetermined time period on power up, and maintains a power supply to the load (3) for a second predetermined time period after power off. Both the first predetermined time period and the second predetermined time period are independently adjustable.

100

FIG. 1

EP 2 667 510 A1

## Description

## Description of Related Art

For some electronic devices, the delay time in many delay circuits are dependent on the product of the resistors and the capacitors that made up the delay circuitry. For many such delay circuits the charging and discharging time of the capacitors can be changed by changing the resistances of the resistors. However, it is difficult to change the charging time without affecting the discharging time or vice versa. This is inconvenient.

Therefore, there is room for improvement in the art.

## Summary

According to an exemplary embodiment of the invention, an electronic device receives a voltage from a power supply. The electronic device includes a load, a first adjusting module, a switching module, a delay module, and a second adjusting module. The first adjusting module produces a working voltage when the electronic device is powered on. The switching module establishes an electrical connection between the first adjusting module and the load when receiving the working voltage, and cuts off the electrical connection when not receiving the working voltage. The delay module delays outputting the working voltage to the load for a first predetermined time period on power up, and maintains a power supply to the load for a second predetermined time period after power off. Both the first predetermined time period and the second predetermined time period are independently adjustable.

## BRIEF DESCRIPTION OF THE DRAWINGS

Many aspects of the embodiments can be better understood with references to the following drawings. The components in the drawings are not necessarily drawn to scale, the emphasis instead being placed upon clearly illustrating the principles of the embodiments. Moreover, in the drawings, like reference numerals designate corresponding parts throughout two views.

FIG. 1 is a block diagram of an electronic device in accordance with one embodiment.

FIG. 2 is a circuit diagram of the electronic device of FIG. 1 in accordance with one embodiment.

## DETAILED DESCRIPTION

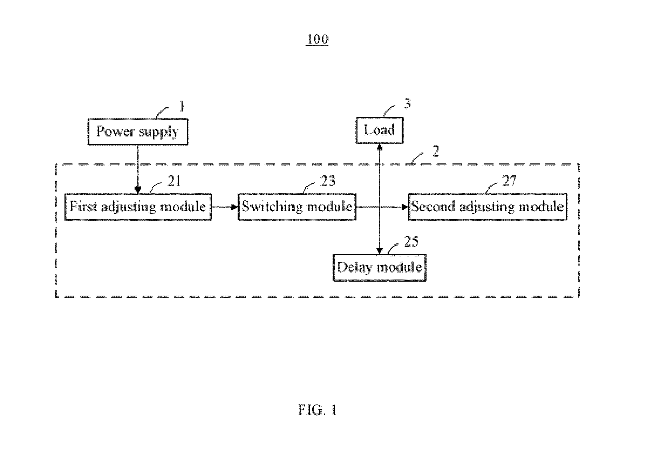

FIG. 1 shows an electronic device 100 of one embodiment of the present disclosure. The electronic device 100 includes a power supply 1, a delay circuit 2, and a load 3. In the embodiment, the electronic device 100 can be a computer or TV, for example.

The power supply 1 provides a voltage to the delay circuit 2. In the embodiment, the power supply 1 is an internal battery. In the other embodiments, the power supply 1 can be an adapter connected to a commercial power supply.

The delay circuit 2 is connected between the power supply 1 and the load 3. The delay circuit 2 is charged gradually and delays outputting the voltage of the power supply 1 to the load 3 for a first predetermined time period when the electronic device 100 is first being powered on. The delay circuit 2 further generates a delay signal for keeping the load 3 working during a second predetermined time period after the electronic device 100 has been powered off. The delay circuit 2 includes a first adjusting module 21, a switching module 23, a delay module 25, and a second adjusting module 27.

The first adjusting module 21 is connected between the power supply 1 and the switching module 23. The first adjusting module 21 outputs a working voltage and can adjust the duration of the first predetermined time period and keep the second predetermined time period unchangeable.

The switching module 23 is connected between the first adjusting module 21 and the delay module 25. The switching module 23 establishes an electrical connection between the first adjusting module 21 and the delay module 25 when the working voltage is received, and, and cuts off the electrical connection between the first adjusting module 21 and the delay module 25 when the working voltage is not supplied.

The delay module 25 is connected to the switching module 23, the second adjusting module 27, and the load 3. The delay module 25 is charged by the working voltage and delays the output of the working voltage to the load 3 for a first predetermined time period when the electronic device 100 is powered on. The delay module 25 further outputs a delay signal which keeps the load 3 supplied with power for a second predetermined time period when the electronic device 100 is powered off.

The second adjusting module 27 is connected to the switching module 23, the delay module 25, and the load 3. The second adjusting module 27 forms a discharge path from the delay module 25 to the load 3 and can adjust the duration of the second predetermined time period and the first predetermined time period at the same time when the electronic device 100 is powered off.

The load 3 is powered by the working voltage to execute a function, such as a playing music or playing a video, for example. In the embodiment, the load 3 is an enable pin of a power IC.

When either the first predetermined time period or the second predetermined time period is being adjusted, the other predetermined time period is not adjusted, that is to say, the respective durations of the first and second predetermined periods of time can be independently adjusted.

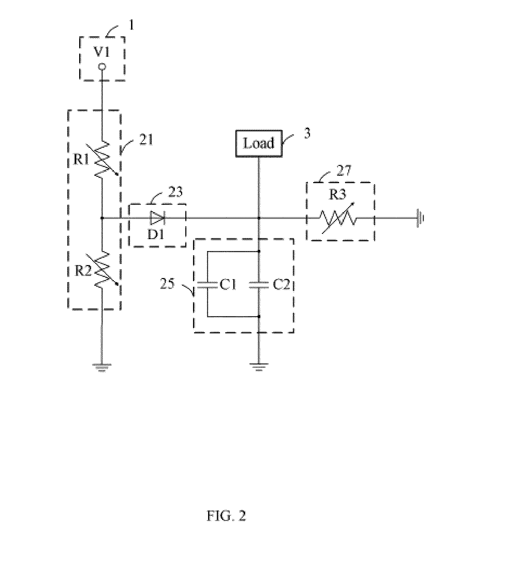

FIG. 2 shows the power supply 1 of the embodiment. The power supply 1 includes a power terminal V1. The first adjusting module 21 includes a first resistor R1 and a second resistor R2. The first resistor R1 and the second resistor R2 are connected in series between the power terminal V1 and ground. In the embodiment, the resistance of first resistor R1 and second resistor R2 are adjustable.

The switching module 23 includes a diode D1. An anode of the diode D1 is connected between the first resistor R1 and the second resistor R2. A cathode of the diode D1 is connected to the delay module 25, the second adjusting module 27, and the load 3.

The delay module 25 includes a first capacitor C1 and a second capacitor C2. The first capacitor C1 and the second capacitor C2 are connected in parallel between the cathode of the diode D1 and ground.

The second adjusting module 27 includes a third resistor R3. An end of the third resistor R3 is connected to the cathode of the diode D1, and other 4 end of the third resistor R3 is grounded. In the embodiment, the resistance of the third resistor R3 is adjustable.

When the power terminal V1 is powered on, the difference in voltage between the anode and the cathode of the diode D1 is greater than 0.3V, and the diode D1 is turned on. The first capacitor C1 and the second capacitor C2 are charged gradually by the voltage of the power terminal V1 through the diode D1. As the first capacitor C1 and the second capacitor C2 are being charged, there is a delay in transmitting the working voltage to the load 3, and after the first predetermined time period the working voltage develops to power up the load 3. The first predetermined time period is calculated according to the following formula:

$$\mathrm{T_{charging}} = \frac{(C1+C2) \times R1 \times \dfrac{R2 \times R3}{R2+R3}}{R1 + \dfrac{R2 \times R3}{R2+R3}} = \frac{C1+C2}{\dfrac{R1+R2}{R1 \times R2} + \dfrac{1}{R3}} \qquad (1)$$

The voltage provided to the load 3 can be calculated according to the following formula:

$$\mathrm{V_{load}} = \frac{V1 \times \dfrac{R2 \times R3}{R2+R3}}{R1 + \dfrac{R2 \times R3}{R2+R3}} = \frac{V1}{\dfrac{R1}{R2} + \dfrac{R1}{R3} + 1} \qquad (2)$$

When the power terminal V1 is powered off, the difference in voltage between the anode and the cathode of the diode D1 is smaller than 0V, and the diode D1 is turned off. The first capacitor C1, the second capacitor C2, and the third resistor R3 forms the discharge path to generate a delay signal for a second predetermined time period, and the load 3 continues to be powered by the delay signal. The second predetermined time period can be calculated according to the following formula:

$$\mathrm{T_{discharging}} = (C1+C2) \times R3 \qquad (3)$$

From the formulas (1)~(3), the first predetermined time period depends on the resistance of the first resistor R1, the second resistor R2, and the third resistor R3. The second predetermined time period relates only to the resistance of the third resistor R3. To change the first predetermined time period and keeping the second predetermined time period and the working voltage unchanged, the resistances of the first resistor R1 and the second resistor R2 are changed and the resistance of the third resistor R3 is not changed. To change the second predetermined time period and keep the first predetermined time period and the working voltage unchanged, the resistances of the first resistor R1, the second resistor R2, and the third resistor R3 are all changed. Thus, the respective durations of the first predetermined time period and the second predetermined time period can be adjusted independently of the other.

It is to be understood, however, that even though information and advantages of the present embodiments have been set forth in the foregoing description, together with details of the structures and functions of the present embodiments, the disclosure is illustrative only; and that changes may be made in detail, especially in matters of shape, size, and arrangement of parts within the principles of the present embodiments to the full extent indicated by the broad general meaning of the terms in which the appended claims are expressed.

**Claims**

1. An electronic device receiving a voltage from a power supply, the electronic device comprising:

   a load;
   a first adjusting module converting the voltage provided by the power supply into a working voltage when the electronic device is powered on and stop converting the voltage into the working voltage when the electronic device is powered off;
   a switching module connected to the first adjusting module and the load;
   a delay module connected to the switching module and the load; and
   a second adjusting module;
   wherein when the switching module establishes an electrical connection between the first adjusting module and the load when receiving the working voltage, the delay module delays outputting the working voltage to the load for a first predetermined time period; when the switching module cuts off the electrical connection between the first adjusting module and the load when not receiving the working voltage, the delay module generates a delay signal for keeping the load enabled for a second predetermined time period; the first adjusting module can adjust the duration of the first predetermined time period and keep the duration of the second predetermined time period unchangeable.

2. The electronic device of claim 1, wherein when the second adjusting module adjusts the duration of the second predetermined time period, and the first adjusting module is being adjusted at the same time for keeping the first predetermined time period unchangeable.

3. The electronic device of claim 1, wherein when the electrical connection between the first adjusting module and the load is established, the delay module is charged gradually.

4. The electronic device of claim 1, wherein when the switching module turns off, the delay module is discharged and the second adjusting module forms a discharge path from the delay module to the load.

5. The electronic device of claim 1, wherein the switching module comprises a diode; an anode of the diode is connected to the first adjusting module; a cathode of the diode is connected to the delay module.

6. The electronic device of claim 1, wherein the first adjusting module comprises a first resistor and a second resistor; the first resistor and the second resistor are connected in series between the power supply and ground; the switching module is connected between the first resistor and the second resistor; the resistance of the first resistor and the second resistor are adjustable.

7. The electronic device of claim 6, wherein the second adjusting module comprises a third resistor; an end of the resistor is connected to the switching module, the other end of the third resistor is grounded; the resistance of the third resistor is adjustable.

8. The electronic device of claim 1, wherein the delay module comprises a first capacitor and a second capacitor; the first capacitor and the second capacitor are connected in parallel between the switching module and ground.

9. A delay circuit receiving a voltage from a power supply and being connected to a load; the delay circuit comprising:

   a first adjusting module converting the voltage provided by the power supply into a working voltage;
   a switching module connected to the first adjusting module and the load;
   a delay module connected to the switching module and the load; and

a second adjusting module;

wherein when the switching module establishes an electrical connection between the first adjusting module and the load when receiving the working voltage, the delay module delays outputting the working voltage to the load for a first predetermined time period; when the switching module cuts off the electrical connection between the first adjusting module and the load when not receiving the working voltage, the delay module generates a delay signal for keeping the load enabled for a second predetermined time period; the first adjusting module can adjust the duration of the first predetermined time period and keep the duration of the second predetermined time period unchangeable.

10. The delay circuit of claim 9, wherein when the second adjusting module adjusts the second predetermined time period, the first adjusting module is being adjusted at the same time for keeping the first predetermined time period unchangeable.

11. The delay circuit of claim 9, wherein when the switching module turns off, the  delay module is discharged and the second adjusting module forms a discharge path from the delay module to the load.

12. The delay circuit of claim 9, wherein the switching module comprises a diode; an anode of the diode is connected to the first adjusting module, a cathode of the diode is connected to the delay module.

13. The delay circuit of claim 12, wherein the delay module comprises a first capacitor and a second capacitor; the first capacitor and the second capacitor are connected in parallel between the cathode of the diode and ground.

14. The delay circuit of claim 9, wherein the first adjusting module comprises a first resistor and a second resistor; the first resistor and the second resistor are connected in series between the power supply and ground; the switching module is connected between the first resistor and the second resistor; the resistance of the first resistor and the second resistor are adjustable.

15. The delay circuit of claim 9, wherein the second adjusting module comprises a third resistor; an end of the resistor is connected to the switching module, the other end of the third resistor is grounded, and the resistance of the third resistor is adjustable.

<u>100</u>

```
                    1                              3
  ┌──────────────┐                      ┌──────┐
  │ Power supply │                      │ Load │
  └──────┬───────┘                      └───▲──┘            2
         │                                  │
  ┌ ─ ─ ─│─ ─ ─ ─ ─ ─ ─ ─ ─ ─ ─ ─ ─ ─ ─ ─ ─│─ ─ ─ ─ ─ ─ ─ ─ ─ ─ ─ ─ ─ ┐
  │      ▼          21              23      │              27           │
  │  ┌───────────────────┐   ┌─────────────────┐   ┌──────────────────────┐ │
  │  │ First adjusting   │──▶│ Switching module│──▶│ Second adjusting     │ │
  │  │ module            │   └────────▲────────┘   │ module               │ │
  │  └───────────────────┘            │            └──────────────────────┘ │
  │                                   │     25                             │
  │                             ┌─────▼──────┐                             │
  │                             │Delay module│                             │
  │                             └────────────┘                             │
  └ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ┘
```

FIG. 1

FIG. 2

Europäisches
Patentamt

European
Patent Office

Office européen
des brevets

## EUROPEAN SEARCH REPORT

Application Number

EP 12 19 5126

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 3 637 913 A (EVANS CHAUNCEY R) 25 January 1972 (1972-01-25) * abstract * * column 6, line 47 - column 6, line 53; figure Fig. 5 * ----- | 1-15 | INV. H03K4/00 H03K5/13 |
| A | US 2005/184786 A1 (NISHIKAWA KOJI [JP]) 25 August 2005 (2005-08-25) * paragraph [0032]; figure Fig 1 * * paragraph [0033]; figure Fig 1 Ref. 3 * ----- | 1-15 | |
| A | US 3 195 055 A (WILLIAM DEAN REGINALD DOUGLAS) 13 July 1965 (1965-07-13) ----- | 1-15 | |
| A | NL 7 211 919 A (CIT ALCATEL) 26 March 1973 (1973-03-26) ----- | 1-15 | |

TECHNICAL FIELDS
SEARCHED        (IPC)

H03K

The present search report has been drawn up for all claims

| Place of search | Date of completion of the search | Examiner |
|---|---|---|
| Munich | 19 September 2013 | Riccio, Ettore |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

................................................................

& : member of the same patent family, corresponding
document

EPO FORM 1503 03.82 (P04C01)

**EP 2 667 510 A1**

## ANNEX TO THE EUROPEAN SEARCH REPORT
## ON EUROPEAN PATENT APPLICATION NO.

EP 12 19 5126

This annex lists the patent family members relating to the patent documents cited in the above-mentioned European search report.
The members are as contained in the European Patent Office EDP file on
The European Patent Office is in no way liable for these particulars which are merely given for the purpose of information.

19-09-2013

| Patent document cited in search report | | Publication date | Patent family member(s) | | Publication date |
|---|---|---|---|---|---|
| US 3637913 | A | 25-01-1972 | NONE | | |
| US 2005184786 | A1 | 25-08-2005 | CN | 1661914 A | 31-08-2005 |
| | | | JP | 2005244413 A | 08-09-2005 |
| | | | KR | 20060042204 A | 12-05-2006 |
| | | | US | 2005184786 A1 | 25-08-2005 |
| US 3195055 | A | 13-07-1965 | GB | 966941 A | 19-08-1964 |
| | | | US | 3195055 A | 13-07-1965 |
| NL 7211919 | A | 26-03-1973 | BE | 788735 A1 | 13-03-1973 |
| | | | DE | 2245400 A1 | 29-03-1973 |
| | | | FR | 2153730 A5 | 04-05-1973 |
| | | | GB | 1339387 A | 05-12-1973 |
| | | | IT | 974641 B | 10-07-1974 |
| | | | LU | 66103 A1 | 19-03-1973 |
| | | | NL | 7211919 A | 26-03-1973 |

For more details about this annex : see Official Journal of the European Patent Office, No. 12/82

9